# EUROPEAN PATENT APPLICATION

(11) **EP 0 860 878 A2**
(43) Date of publication of application: **26.08.1998**
(21) Application number: 98102594.3
(22) Date of filing: 16.02.1998
(51) Int. Cl.: H01L 23/525

(54) **An integrated circuit with programmable elements**

(30) Priority: 20.02.1997 US 38706 P
(71) Applicant: Texas Instruments Incorporated, Dallas, Texas 75251 (US)
(72) Inventor: Komai, Yutaka, Tsuchiura-City, Ibaraki (JP); Norwood, Roger, (nmi), Sugarland, Texas 77478 (US)
(74) Representative: Schwepfinger, Karl-Heinz, Dipl.-Ing.

(57) **Abstract**

In one embodiment, the present invention provides a technique to implement programmable elements such as fuses more efficiently than prior art methods. In one embodiment, a blocking layer 16 is disposed over a semiconductor layer 10. A fuse layer 20, which includes at least one programmable element, is formed above the blocking layer 16. The blocking layer 16 is selected from a material which will protect the underlying semiconductor layer 10 from the mechanism used to alter the fuses formed above. For example, if a laser is used to blow a fuse then the blocking layer 16 will not transmit laser light. Preferably, a passivation layer 14 is formed between the blocking layer 16 and the semiconductor layer 10.

## Description

### FIELD OF THE INVENTION

This invention relates generally to semiconductor devices and specifically to an integrated circuit with programmable elements.

### BACKGROUND OF THE INVENTION

The present invention relates to an integrated circuit which includes a programmable element such as a fuse. Fuses can be used in a great number of embodiments. For example, fuses can be used for calibration circuits. One reference which teaches an analog-to-digital converter which includes an on-board self calibration system is U.S. Patent No. 4,399,426. This patent teaches a plurality of switches used in a calibration system. These switches can be fuses.

As another example, memory arrays often include redundant memory cells which can be selectively used to replace a defective memory cell in the standard array. This technique allows for an increase in overall yield since some devices which include defective portions can still be sold. Examples of redundant memory arrays are provided in U.S. Patent No. 4,228,528, U.S. Patent No. 4,346,459, U.S. Patent No. 4,389,715, U.S. Patent No. 4,601,019, and U.S. Patent No. 5,220,535.

With the progress of semiconductor productization, minimum design-rules have reached into the sub-micron realm and redundancy is becoming more important.

Because of miniaturization, semiconductor devices can be even more greatly affected by small particles found in air, chemicals, and processing equipment. These particles can easily cause electrical failures. To combat this problem, designers are adding more redundancy circuits into new submicron devices in order to replace the defective areas and improve yields. The problem with this approach, however, is the increase in chip size required to contain these additional circuits.

In addition, design rules for the redundancy fuse area have not reduced with higher integration due to the beam size, the focus depth and the overall accuracy of the laser repair equipment. As a result, the portion of the total chip area dedicated to the fuse circuits is becoming larger.

### SUMMARY OF THE INVENTION

The present invention provides a technique to implement programmable elements such as fuses more efficiently than prior art methods. In one embodiment, a blocking layer is disposed over a semiconductor substrate. A fuse layer, which includes at least one fuse element, is formed above the blocking layer. The blocking layer is selected from a material which will protect the underlying substrate from the mechanism used to alter the fuses formed above. For example, if a laser is used to blow a fuse then the blocking layer will now allow laser light to pass. Preferably, a passivation layer is formed between the blocking layer and the substrate.

The present invention provides a number of advantages over the prior art. Since the fuses are formed above the substrate, chip area is saved. As a consequence, more chips can be formed on a single wafer. In addition, since the fuse circuits take up less area, more of them can be included for each device. For example, in a memory array, an increase in the number of redundancy circuits will lead to an increase in the number of usable chips, that is, an increase in yield.

### BRIEF DESCRIPTION OF THE DRAWINGS

The present invention will now be further described by way of example, with reference to the accompanying drawings in which:
Figure 1 is a cross-sectional view of a first embodiment of the present invention;
Figures 2a and 2b are cross-sectional views of two of the circuitry types which could be utilized with the embodiment of Figure 1;
Figures 3a-3c are plan views of three different fuses;
Figure 4 is a cross-sectional view of a second embodiment of the present invention;
Figure 5 is a plan view of a preferred example of the embodiment of Figure 4; and
Figures 6a and 6b provide an example of a specific application which can utilize the teachings of the present invention.

### DETAILED DESCRIPTION OF ILLUSTRATIVE EMBODIMENTS

The making and use of the various embodiments are discussed below in detail. However, it should be appreciated that the present invention provides many applicable inventive concepts which can be embodied in a wide variety of specific contexts. The specific embodiments discussed are merely illustrative of specific ways to make and use the invention, and do not limit the scope of the invention.

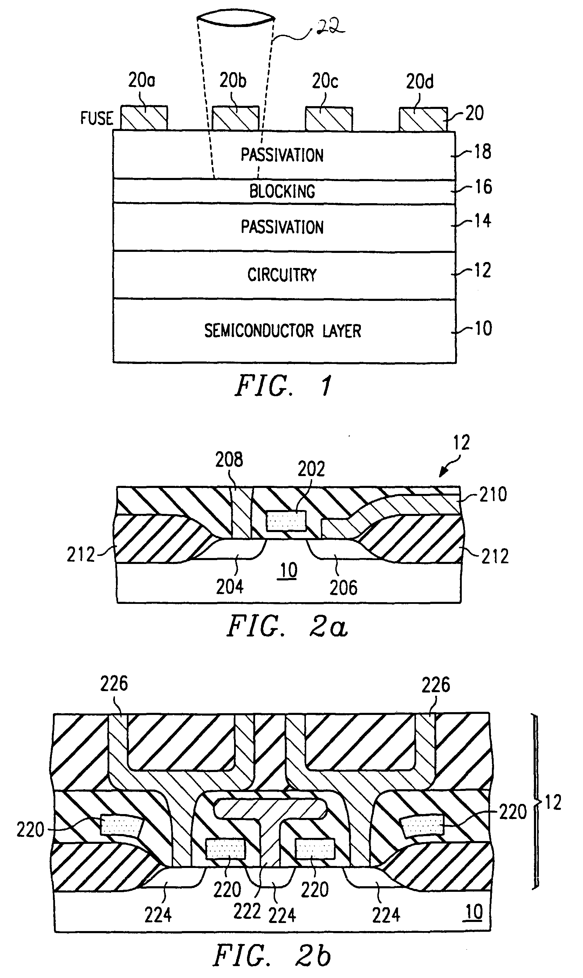

In one aspect, a preferred embodiment of the present invention relates to a fuse region which may be disposed in an upper level of metal. By relocating the fuses from a lower level of metal or polysilicon to this upper level, chip area is saved. One may hesitate to locate fuses above other circuitry for fear that the other circuitry may be damaged when the fuses are blown. To avoid this problem, a further preferred embodiment of the present invention discloses a blocking layer which will block the energy used to blow fuses from any underlying circuitry. Figure 1 can be used to illustrate this feature.

Figure 1 illustrates a simplified cross-sectional view of a first embodiment of the present invention. An integrated circuit region 12 is formed on a semiconductor layer 10. The semiconductor layer 10 may comprise a semiconductor substrate, a semiconductor layer formed on another layer such as a substrate or an insulating layer (e.g.SOI), or a doped semiconductor region formed within a semiconductor layer (e.g. a well, a tank or a tub). The only limitation on the layer 10 is that it be capable of maintaining active (or passive) circuitry at the face. In the preferred embodiment, the semiconductor layer 10 is a silicon layer but other semiconductors such as gallium arsenide, germanium or mercury cadmium telluride can be used.

Circuit region 12 is disposed at the face of semiconductor layer 10. Region 12 includes active and/or passive circuitry formed at the face of semiconductor layer 10. Region 12 can include any circuit elements formed in the integrated circuit including transistors, diodes, capacitors, resistors, interconnects and others. Region 12 also includes isolation regions such as field (thick) oxides.

It is noted that illustrating circuit region 12 as being distinct from semiconductor layer 10 is misleading since many elements will be included within both layers. The reader is warned not to interpret the drawing in Figure 1 too literally. Figures 2a and 2b illustrate this point.

Two examples of portions of circuit regions 12 ace provided in Figures 2a and 2b. Figure 2a illustrates a transistor device formed at the face of semiconductor layer 10. The transistor includes gate region 202, source/regions 204 and 206, contact 208, interconnect 210 and field oxide regions 212. Figure 2b illustrates two dynamic random access memory (DRAM) cells formed at the face of semiconductor layer 10. The DRAM cells include pass gates (word lines) 220, bit line 222, doped regions 224 and capacitor storage nodes 226. These two examples are provided to illustrate some of the elements which could be treated as a circuit layer 12. It should be understood that many other circuit elements and combinations would also meet this definition.

Returning to Figure 1, a passivating layer 14 is disposed above circuit region 12. The passivating layer 14 typically comprises an insulating layer such as BPSG (borophosphosilicate glass). Other materials such as oxide formed by the decomposition of tetraethyloxysilane (TEOS) or spin-on-glass (SOG) may alternatively be used. The function of the passivating layer is to isolate blocking layer 16 from circuit region 12. For example, if blocking layer 16 is conductive, it could short circuit some of the elements within circuit region 12. If, on the other hand, circuit region 12 does not need to be isolated from blocking layer 16, then passivation layer 14 can be eliminated.

As mentioned above, blocking layer 16 is disposed above circuit region 12 (and passivation layer 14, if included). The blocking layer 16 is selected from a material which will protect the underlying substrate 10 (and active region 12) from the mechanism used to alter the fuses formed above. For example, lasers are most often used to blow fuses. In that case, blocking layer 16 will not be selected from a material which will protect the underlying substrate 10 (and active region 12) from the mechanism used to alter the fuses formed above. For example, lasers are most often used to blow fuses. In that case, blocking layer 16 will not be selected from a material that will not allow laser light to pass. In the preferred embodiment, blocking layer 16 is formed from a metal such as aluminum, tungsten and titanium for example.

Some devices may include more metal layers. For example, four metal layers could be used. In this case, more than one layer could be used as a blocking layer 16.

A second passivation layer 18 is disposed over blocking layer 16. The passivation layer 18 is preferably formed from BPSG but other materials such as TEOS or SOG can alternatively be used. If fuse layer does not need to be isolated from blocking layer 16, then passivation layer 18 can be eliminated.

Fuse layer 20 is disposed over the second passivation layer. The fuse layer 20 is the layer from which programmable elements are formed. For example, metal fuses 20a-20d are included in the fuse layer 20 will be a metal layer. Similarly, if polysilicon fuses are included, the fuse layer 20 will be a polysilicon layer.

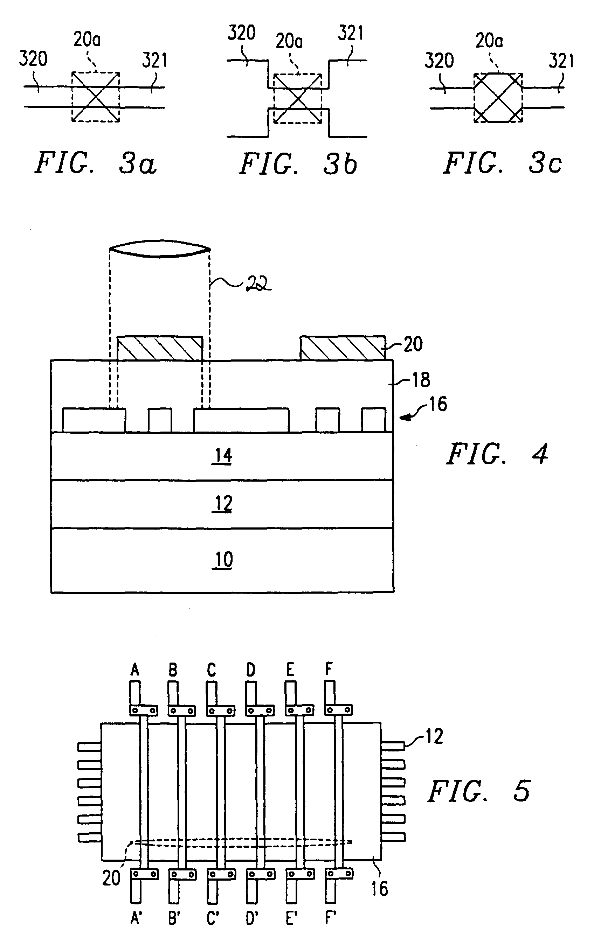

Figures 3a-3c illustrate three possible configurations for the individual fuse elements 20a. In Figure 3a, the fuse element 20a is simply a conductive line which can be opened so that nodes 320 and 321 are electrically isolated. If the fuse 20a is not blown, nodes 320 and 321 will be ohmically coupled (preferably with a very low resistance). Figures 3b and 3c illustrate two variations of the fuse in Figure 3a. In Figure 3b the portion to be blown is narrower than the remaining conductors 320/321 while in Figure 3c the portion of fuse 20a to be blown is wider than the remaining conductors 320/321.

As mentioned above, in order to blow a fuse 20a, energy 22 from an energy source 24 is directed at the fuse. For example, laser light 22 may be directed from a laser source 24 as illustrated in Figure 1. The light 22 will impinge the fuse 20a and travel through passivation layer 18 until reaching blocking layer 16. At least partly due to the choice of materials, the light 22 will not go through blocking layer 16 (e.g. will be blocked). This blocking mechanism will protect elements beneath blocking layer 16 from the energy in beam 22.

In one embodiment, the portions of active region 12 directly beneath fuse elements 20a-20d are not used for any wiring or circuits. In other words, isolation regions are formed directly beneath the fuse elements 20a-20d. In this context, one element is directly beneath (or directly above) another element if a line perpendicular to the plane of the substrate could intersect both elements. One element is above another element if it is farther from the substrate than the other element.

In another embodiment, fuse elements 20a-20d can be disposed directly above active or passive circuit elements (e.g. transistors, interconnects). This embodiment is advantageous since the chip size can be reduced. In this case, the blocking layer 16 will protect the circuits within region 12 from the laser. In general, the blocking layer 16 will be between the fuse (and surrounding laser damage area) and the circuitry below it. But it may not be exactly underneath. Within a few microns may very well suffice for the purposes of this invention.

Embodiments of the present invention have another advantage in that they can be readily incorporated into existing designs. Figure 4 illustrates one example of this advantage. The structure of Figure 4 is the same as that of Figure 2 except that the blocking layer 16 is illustrated as a patterned layer. In this example, wiring patterns can be added to the blocking layer 16 as long as they are carefully laid out under the fuses. As illustrated in Figure 4, blocking layer 16 does not need to be directly under the entire fuse 20a. The blocking layer 16 layer could only be directly beneath the edges of fuse 20a since any energy impinging the fuse 20a will be absorbed by the fuse 20a. The precise requirements of blocking layer 16 will be determined by the accuracy of the laser.

As an example, consider a multilayer device. The circuit layer 12 can include one or more polysilicon layers (e.g. polyl, poly2) and possibly one or more metal layers (e.g. metal 1). In this example, blocking layer 16 could be formed within a metal layer (e.g. metal 2). This metal layer could simultaneously serve as routing for the power supplies (e.g. ground, V_{DD}, an internally generated voltage such as V_{BB}, V_{PP}, V_{DD INT}). In this case, blocking layer 16 would be coupled to a fixed voltage level (e.g., 0 volts, 5 volts, 3.3 volts, 2.5 volts, -2 volts.

Continuing with the example, the fuses would be formed in another metal layer (e.g. metal 3). Since these metal layers are already needed for other purposes and have not been fully utilized, the fuses are practically free in terms of chip area.

Figure 5 shows a plan view of the blocking layer 16 and fuses 20a-20d formed above. In this example, the fuses 20a-20d are laid out next to one another over the wider metal layer 16. As illustrated in the figure, other circuitry 12 ban be disposed beneath the blocking layer 20. In this example, layer 20 can be a third metal layer, layer 16 can be a second metal layer and region 12 can include a first metal layer.

It is noted that the "blocking layer" 16 can be used for other purposes (such as signal routing, or power routing) in addition to acting as a blocking layer. In fact, areas of the chip where there are no fuses will use the blocking layer 16 exclusively for other purposes. Of course, that is also true of the "fuse layer" 20. It will likely be used for lots of things besides just fuses.

In the preferred embodiment, the fuses 20a-20d are formed within the uppermost conductive layer. The uppermost layer is the layer which is farthest from the substrate 10. This choice is made for practical purposes. It may not be possible to test the device until after all the layers are formed and therefore there would be no way to tell which fuses are to be blown until that time. Therefore, the fuses would be most accessible in the uppermost layer. It is understood, however, that the fuses could be formed in another layer. The only true requirement is that the fuses must be accessible when it is time to program them.

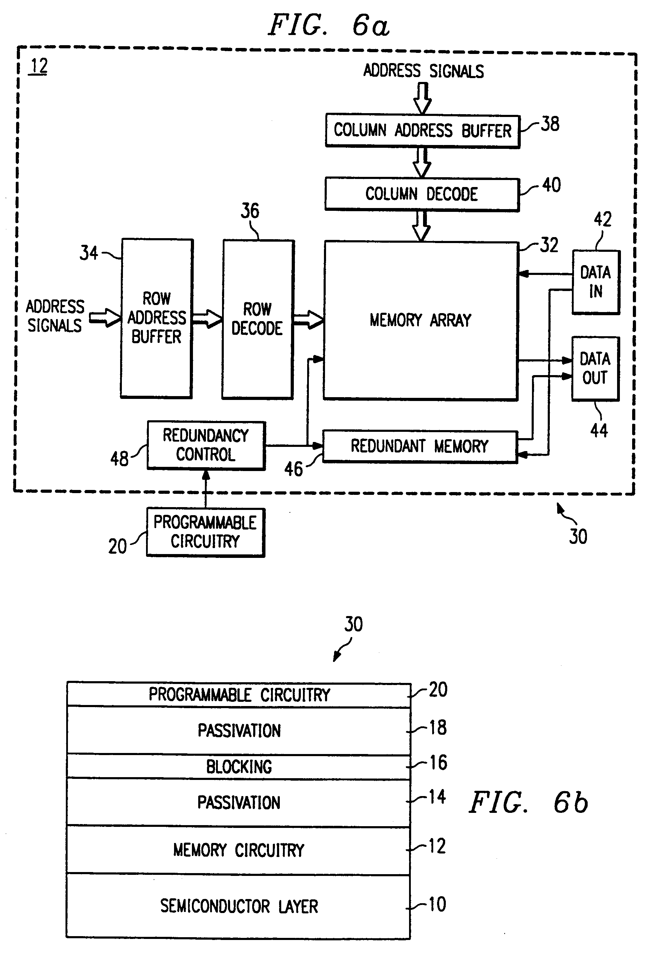

A specific example of an application which could utilize the teachings of the present invention is provided in Figures 6a and 6b. These embodiments teach a memory array for a memory device such as a DRAM. Other memory devices such as SRAMs, non-volatile memories (EPROMs, EEPROMs, flash) could also utilize the teachings of the present invention.

Referring now to Figures 6a and 6b together, a memory device 30 will be described. The memory circuitry 12 is formed in and above a semiconductor layer 10. As before, semiconductor layer 10 can comprise a substrate, a layer over a substrate or a region within another layer. An array 32 of memory cells is provided in rows and columns. This array can include a large number of memory cells. For example, the array can include 64Meg of memory (i.e.67,108,864 memory cells). Alternatively, DRAM arrays can include 256Meg, 1 Gig or even 4 Gig or more.

A row address buffer 34 is formed at the face of the layer 10. The row address buffer 34 receives row address signals. These row address signals can be generated externally of the device 30 or may be generated on the same chip (e.g. if the memory 30 is embedded in a chip with other circuitry). A row decoder 36 receives the address signals from the row address buffer 34. Row decoder 36 can then select at least one of the rows of memory cells in array 32.

A column address buffer 38 is also formed at the face of semiconductor layer 10. Column address buffer 38 is coupled to receive column address signals from either an internal or external source. Column decoder 40 receives the column address signals from column address buffer 38 and selects at least one of the columns of memory cells in array 32. In some embodiments, the column address signals are latched into the column address buffer 38 at a different time than the row address signals are latched into the row address buffer 34. This technique is useful in embodiments where a single set of external pins (not shown) are used for receiving both the row and column addresses. In other embodiments, such as embedded memories for example, the address signals may be received at the same time.

The embodiment of Figure 6a also includes a data input buffer 42. Data input buffer 42 receives at least one data input signal. The data input buffer is operably coupled to the array of memory cells 32 such that the data input signal can be written to the array. In wide-word memory devices, a number of data input signals can be transferred simultaneously.

A data output buffer 44 is also provided. Data output buffer 44 is coupled to receive at least one data output signal. The data output buffer 44 is also operably coupled to the array of memory cells 32 such that the data output signal can be read from the array. The data input buffer 42 and data output buffer 44 are preferably coupled to memory array 32 though common bus lines (not shown). In addition, the input and output buffers 42 and 44 may provide data to a shared external pin (not shown). Once again, the input and output data may come from sources/destinations on the same chip for some embodiments such as embedded memories.

The memory device 30 also includes a plurality of redundant memory cells 46. The redundant memory cells 46 are coupled so as to be operable to receive data input signals from the data input buffer 42 upon application of a redundancy signal. Redundant memory cells 46 are also coupled so as to be operable to transfer data output signals to the data output buffer 44 upon application of a redundancy signal (which may or may not be the same signal for reading and writing). The redundancy signals can be generated in redundancy control circuit 48.

Programmable circuitry 20 is provided to store information from which the read and write redundancy signals are generated. For example, information regarding which columns and/or rows should be replaced are stored in a plurality of fuses within programmable circuitry 20.

As described in the more generic description of the present invention, programmable circuitry 20 is formed over a blocking layer 16. As before, the blocking layer 16 will protect the underlying circuitry 12, while the programmable elements 20 are being programmed. Once again, both of these conductive layers 16 and 20 will likely serve other purposes besides blocking and fuses.

While only a specific example of the present invention has been provided, it should be understood that a large number of devices could utilize the teachings provided herein. For example, the present invention could be used with processors such as microprocessors and digital signal processors. The present invention could also be used with mixed signal devices such as analog-to-digital converters, digital-to-analog converters, amplifiers, and charge coupled devices, as just a few examples. Basically, the present invention could be utilized with any integrated circuit which includes programmable elements.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description.

## Claims

1. An integrated circuit comprising:
a semiconductor layer;
a circuit region disposed over a face of the semiconductor layer;
a blocking layer disposed over the circuit region; and
a fuse layer disposed over the blocking layer wherein at least one programmable element is formed within the fuse layer directly above the blocking layer.

2. The integrated circuit of Claim 1, wherein the blocking layer comprises a metal layer.

3. The integrated circuit of Claim 2, wherein the blocking layer comprises an aluminum layer.

4. The integrated circuit of any preceding Claim further comprising;
a circuit element formed at the face of the semiconductor layer, wherein the programmable element is formed directly above the circuit element.

5. The integrated circuit of Claim 4, wherein the circuit element comprises an interconnect.

6. The integrated circuit of any preceding Claim, wherein the blocking layer comprises a patterned portion which is not beneath any programmable elements, the patterned portion being electrically coupled to the circuit region.

7. The integrated circuit of any preceding Claim, wherein the fuse layer comprises a patterned portion which is spaced from the programmable element, the patterned portion being electrically coupled to the circuit region.

8. The integrated circuit of any preceding Claim, wherein the blocking layer serves as a power bus for circuitry below the blocking layer.

9. The integrated circuit of any preceding Claim, wherein the blocking layer comprises a conductive layer which is electrically coupled to a supply voltage node.

10. The integrated circuit of Claim 8, wherein the blocking layer is electrically coupled to ground.

11. The integrated circuit of any preceding Claim, wherein the fuse layer comprises a metal layer.

12. The integrated circuit of any preceding Claim, further comprising an array of memory cells formed over a face of the semiconductor substrate.

13. The integrated circuit of Claim 12, wherein the memory cells comprise dynamic random access memory cells.

14. The integrated circuit of Claim 12 or Claim 13, wherein the array of memory cells comprise at least sixty-four million dynamic random access memory cells.

15. The integrated circuit of any of Claims 12 to 14, wherein the memory cells comprise non-volatile memory cells.

16. The integrated circuit of any preceding Claim, further comprising a thick insulating region disposed over a face of the substrate wherein the fuse element is formed substantially above the thick insulating region.

17. The integrated circuit of any preceding Claim, wherein:
a patterned polysilicon layer is disposed over the semiconductor substrate;
a first patterned metal layer is disposed over the polysilicon layer and insulated therefrom, wherein the blocking layer is formed from the first metal layer; and
a second patterned metal layer is disposed over the first metal layer and insulted therefrom, wherein the fuse layer is formed from the second metal layer.

18. The integrated circuit of Claim 17, further comprising a third metal layer, the third metal layer disposed beneath the second metal layer.

19. The integrated circuit of any preceding Claim, wherein the fuse layer comprises an uppermost metal layer.

20. The integrated circuit of Claim 1, and further comprising a passivation layer between the fuse layer and the blocking layer.

21. The integrated circuit of any preceding Claim, further comprising a passivation layer between the semiconductor layer and the blocking layer.

22. A memory device comprising:
an array of memory cells formed in rows and columns at a face of a semiconductor layer;
a row address buffer formed at the face of the layer, the row address buffer being arranged for receiving row address signals,
a row decoder formed at the face of the layer, the row decoder being arranged for receiving the row address signals from the row address buffer and for selecting at least one of the rows of memory cells;
a column address buffer formed at the face of the layer, the column address buffer being arranged for receiving column address signals;
a column decoder formed at the face of the layer, the column decoder being arranged for receiving the column address signals from the column address buffer and for selecting at least one of the columns of memory cells;
a data input buffer formed at the face of the layer, the column decoder being arranged for receiving the column address signals from the column address buffer and for selecting at least one of the columns of memory cells;
a data input buffer formed at the face of the layer, the data input buffer being arranged for receiving at least one data input signal, the data input buffer being operably coupled to the array of memory cells such that the data input signal can be written to the array;
a data output buffer formed at the face of the layer, the data output buffer being arranged for receiving at least one data output signal, the data output buffer being operably coupled to the array of memory cells such that the data output signal can be read from the array;
a plurality of redundant memory cells formed at the face of the layer, the redundant memory cells coupled so as to be operable to receive the at least one data input signal from the data input buffer upon application of a redundancy signal;
a blocking layer disposed over the semiconductor layer; and
a plurality of fuse elements disposed over the blocking the layer, the fuse circuits coupled to affect at least one of the redundancy read signal and the redundancy write signal.

23. The device of Claim 22, wherein the row address signals, the column address signals, the at least one data input signal and the at least one data output signal are generated by a circuit external to the semiconductor layer.

24. The device of Claim 23, wherein at least one data input signal and at least one data output signal are provided to the semiconductor layer at a single external pin.

25. The device of any of Claims 22 to 24, wherein the row address signals, the column address signals, the at least one data input signal and the at least one data output signal are generated by a circuit formed at the face of the layer.

26. The device of any of Claims 22 to 25, wherein the face of the semiconductor layer comprises an expitaxially grown layer.

27. The device of any of Claims 22 to 26, wherein the face of the semiconductor layer comprises a semiconductor layer disposed over an insulating layer.

28. A method of manufacturing a semiconductor device, the method comprising the steps of:
forming circuitry at a face of a semiconductor layer;
forming a first passivating layer over the semiconductor layer;
forming a blocking layer over the passivating layer;
forming a second passivating layer over the blocking layer;
forming a fuse layer over the second passivating layer, the fuse layer having at least one programmable element formed therein.

29. The method of Claim 28, further comprising the step of programming at least one programmable element within the fuse layer.
